# EUROPEAN PATENT APPLICATION

(11) **EP 2 562 738 A1**
(43) Date of publication of application: **27.02.2013**
(21) Application number: 11771698.5
(22) Date of filing: 16.02.2011
(51) Int. Cl.: G09F 9/30, G02F 1/1368, H01L 21/768

(54) **DISPLAY DEVICE AND PROCESS FOR PRODUCING SAME**

(30) Priority: 19.04.2010 JP 2010096080
(71) Applicant: Sharp Kabushiki Kaisha, Osaka-shi, Osaka 545-8522 (JP)
(72) Inventor: FUJITA, Tetsuo, Osaka 545-8522 (JP); HARA, Yoshihito, Osaka 545-8522 (JP); NAKATA, Yukinobu, Osaka 545-8522 (JP)
(74) Representative: Müller - Hoffmann & Partner
(86) International application number: PCT/JP2011/000854
(87) International publication number: WO 2011/132353

(57) **Abstract**

A method for fabricating a display device includes the steps of forming a multilayer structure in which a first conducting film and a second conducting film are stacked in this order, removing part of the second conducting film and forming a contact region in which the first conducting film does not overlap with the second conducting film, thereby forming the electrode portion from the multilayer structure, forming a planarized film made of a photosensitive material on the substrate on which the electrode portion is formed to cover the electrode portion, thereby forming a contact hole located inside the contact region and passing through the planarized film, and forming a pixel electrode on a surface of the planarized film to cover part of the first conducting film located inside the contact hole and exposed from the planarized film.

## Description

### TECHNICAL FIELD

The present disclosure relates to display devices, for example, liquid crystal display devices, etc. and a method for fabricating such devices.

### BACKGROUND ART

In recent years, a demand for active matrix display devices, e.g., liquid crystal display devices, etc. has greatly increased, and such devices have been used in many areas, such as so-called liquid crystal televisions, or mobile telephones, etc. Along with this trend, it has been strongly required to achieve high-definition display in the market.

A conventional display device will be described using a liquid crystal display device as an example. In general, a liquid crystal display device includes a TFT substrate in which a plurality of TFTs (thin film transistors) are provided so that each of the TFTs is provided in each of a plurality of pixels, a counter substrate facing the TFT substrate, and a liquid crystal layer sealed between the TFT substrate and the counter substrate.

In the TFT substrate, a plurality of TFTs are formed on, e.g., a glass substrate, and each of the TFTs is covered by a passivation film (hereinafter referred to as the PAS film) serving as a protective film. Besides, a planarized film is formed on the surface of the PAS film. A pixel electrode made of ITO (Indium Tin Oxide), etc. is formed on the surface of the planarized film. A contact hole is formed in the PAS film so as to conduct the TFT and the pixel electrode to each other.

It has generally been known that, in order to form a contact hole in the PAS film by photolithography, the planarized film is made of a photosensitive organic insulating film, and the organic insulating film is used as a resist (for example, see Patent Document 1, etc.). According to this technique, the resist for forming the contact hole functions as a planarized film, whereby a step of removing the resist is not needed to reduce the number of steps.

Recently, as the size of liquid crystal display devices and the display resolution have increased, it has been required to form wirings with a low resistance metal material. As a material for a low resistance metal wiring, an attention has been drawn to an aluminum or an aluminum alloy including aluminum as a main component since these materials are relatively inexpensive and are preferably formed as a film. It has also been required to reduce costs for fabricating the liquid crystal display devices.

Patent Document 2 discloses using an aluminum alloy film as a material for constituting a drain lead electrode, and a structure in which a contact hole is formed in an interlayer insulating film made of a silicon nitride film and covering the drain lead electrode. The contact hole is formed in a regin in which the drain lead electrode exists and in a region in which the drain lead electrode does not exist. With this structure, when a pixel electrode is formed on the interlayer insulating film and the drain lead electrode in the contact hole, disconnection of the pixel electrode does not occur in the region in which the drain lead electrode is not formed, thereby making it possible to reliably connect the pixel electrode and the drain lead electrode together.

### CITATION LIST

### PATENT DOCUMENT

PATENT DOCUMENT 1: Japanese Patent Publication No. 2001-272698
PATENT DOCUMENT 2: Japanese Patent Publication No. 2000-199917

### SUMMARY OF THE INVENTION

### TECHNICAL PROBLEM

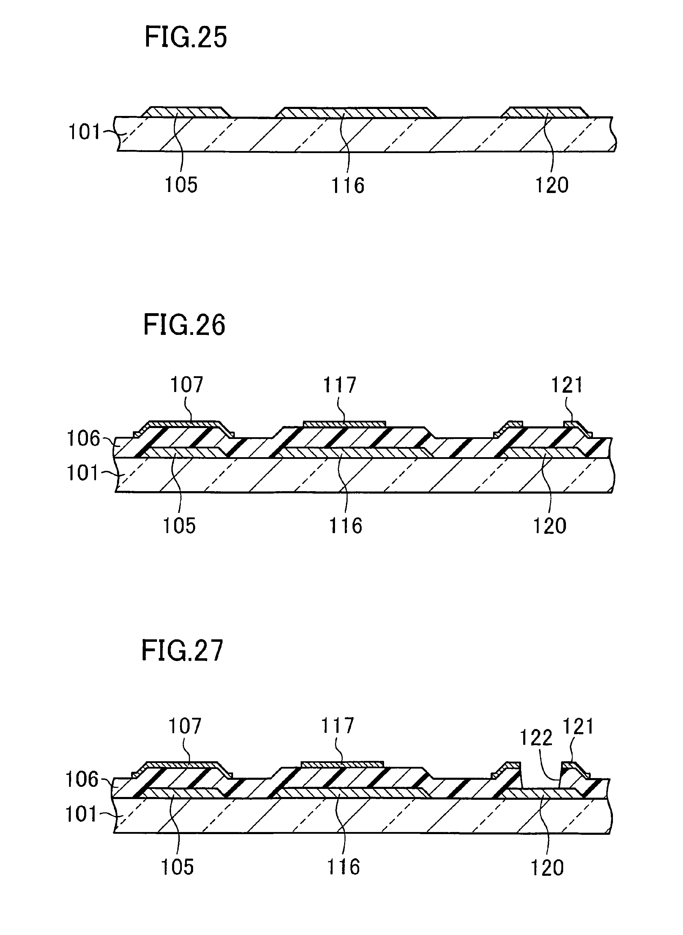

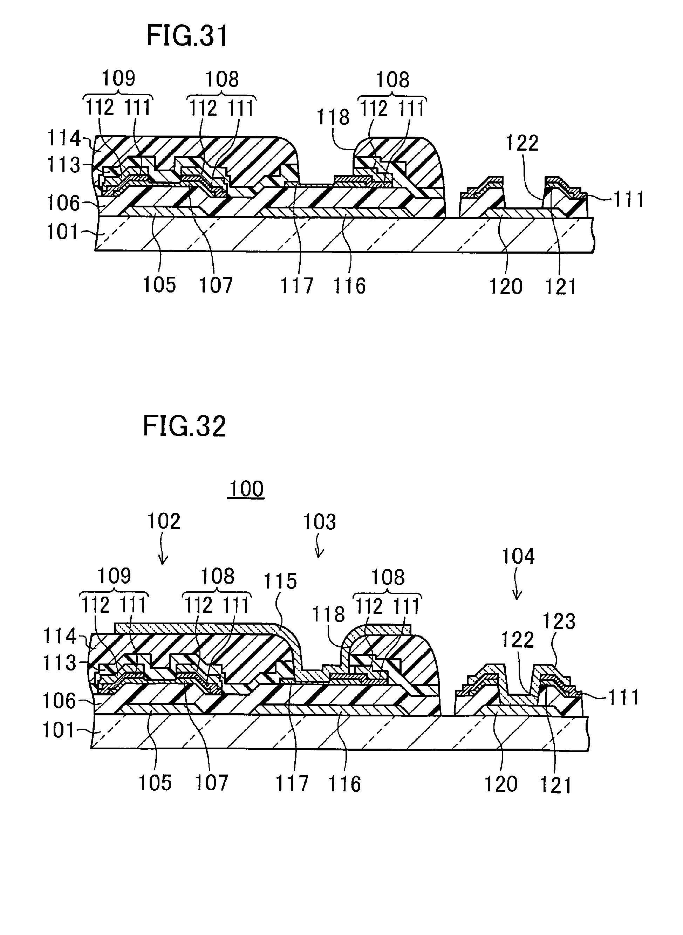

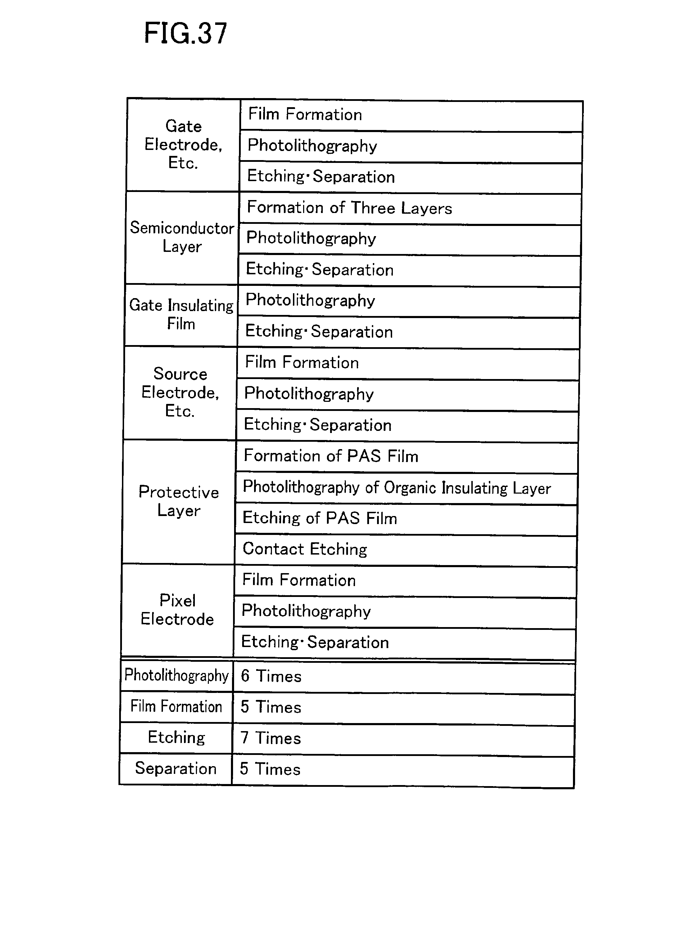

A related art of the present invention will be described with reference to FIGS. 25-37. FIG. 32 is an enlarged cross-sectional view showing part of a TFT substrate of the related art of the present invention. FIGS. 25-31 are cross-sectional views showing steps of fabricating the TFT substrate in FIG. 32. FIG. 37 is a table explaining the steps of fabricating the TFT substrate.

In Patent Document 2, the interlayer insulating film in which the contact hole is formed is a single layer of a silicon nitride film, whereas in the related art, the interlayer insulating film includes two layers of a PAS film and an organic insulating film.

As shown in FIG. 32, a TFT substrate 100 includes a TFT portion 102 formed on a glass substrate 101, a contact hole portion 103, and a terminal portion 104. The TFT portion 102 includes a gate electrode 105 formed on the glass substrate 101, a gate insulating film 106 covering a gate electrode 105, a semiconductor layer 107 formed on the gate insulating film 106, and a drain lead electrode 108 and a source lead electrode 109 formed on the surface of the semiconductor layer 107.

Each of the drain lead electrode 108 and the source lead electrode 109 includes a lower layer of a titanium film 111 and an upper layer of an aluminum film 112. The semiconductor layer 107, the drain lead electrode 108, and the source lead electrode 109 are covered by a PAS film 113. Besides, a photosensitive organic insulating film 114 is stacked on the surface of the PAS film 113. The surface of the organic insulating film 114 is planarized, and on the surface thereof, a pixel electrode 115 made of ITO is formed.

The contact hole portion 103 includes an auxiliary capacitor line 116 formed on the glass substrate 101, a gate insulating film 106 covering the auxiliary capacitor line 116, a semiconductor layer 117 formed on the surface of the gate insulating film 106, and the drain lead electrode 108 partially covering the semiconductor layer 117. The drain lead electrode 108 is connected to the drain lead electrode 108 in the TFT portion 102.

On the auxiliary capacitor line 116, the PAS film 113 covering the drain lead electrode 108 and the source lead electrode 109, and the organic insulating film 114 are formed, and a contact hole 118 passing through the PAS film 113 and the organic insulating film 114 are formed. The pixel electrode 115 electrically connected to the drain lead electrode 108 is formed on the inner surface of the contact hole 118.

The terminal portion 104 includes a lower terminal layer 120 formed on the glass substrate 101, the gate insulating film 106 covering the lower terminal layer 120, a semiconductor layer 121 formed on the surface of the gate insulating film 106, and a titanium film 111 formed to cover the semiconductor layer 121. A contact hole 122 passing through the titanium film 111, the semiconductor layer 121, and the gate insulating film 106 is formed on the lower terminal layer 120. On the surface of the titanium film 111, an upper terminal layer 123 connected to the lower terminal layer 120 through the contact hole 122 is formed. The upper terminal layer 123 is made of ITO.

Next, a method for fabricating the TFT substrate 100 will be described.

First, as shown in FIG. 25, photolithography and etching are performed with respect to a metal film formed on the surface of the glass substrate 101, thereby forming the gate electrode 10⁵, the auxiliary capacitor line 116, and the lower terminal layer 120. Next, as shown in FIG. 26, after the gate insulating film 106 covering the gate electrode 105, the auxiliary capacitor line 116, and the lower terminal layer 120 is formed, a semiconductor material layer is formed on the surface of the gate insulating film 106. Subsequently, photolithography and etching are performed with respect to the semiconductor material layer, thereby forming semiconductor layers 107, 117, and 121 in an island shape.

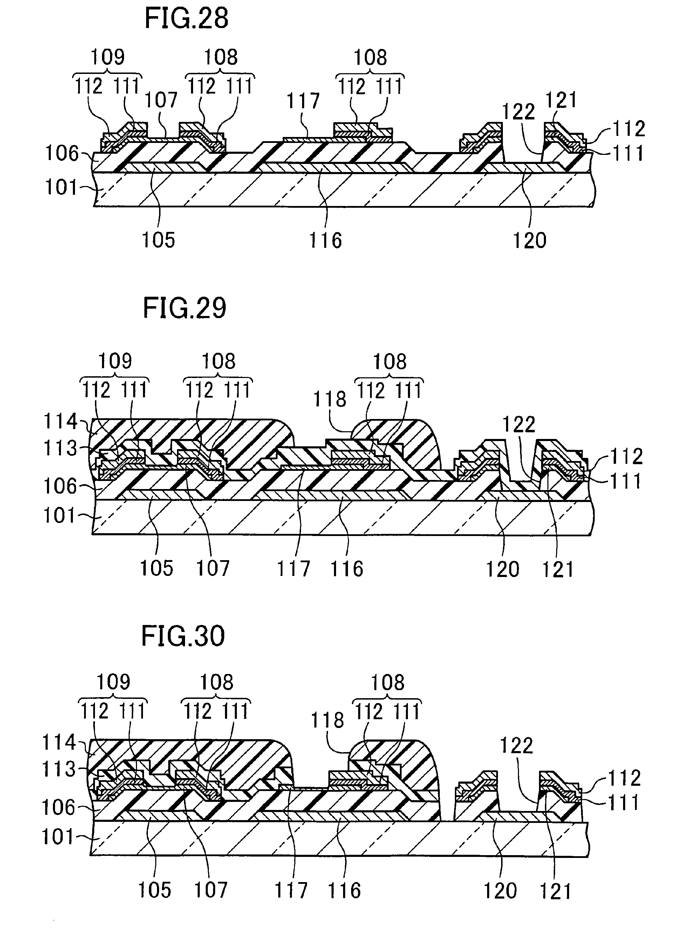

Next, as shown in FIG. 27, the contact hole 122 passing through the semiconductor layer 121 and the gate insulating film 106 is formed on the lower terminal layer 120 by photolithography and etching. Next, as shown in FIG. 28, after a titanium material layer and an aluminum alloy material layer are formed in this order, photolithography and etching are performed with respect to them, thereby forming the drain lead electrode 108 and the source lead electrode 109 in a region for forming the TFT portion 102, and forming a multilayer structure including the titanium film 111 and the aluminum film 112 in an island shape in each of a region for forming the contact hole portion 103 and a region for forming the terminal portion 104. At this time, in the region for forming the contact hole portion 103, part of the semiconductor layer 117 is exposed from the multilayer structure.

Next, as shown in FIG. 29, the PAS film 113 made of silicon nitride is formed so as to cover the drain lead electrode 108, etc. In addition, the organic insulating film 114 is formed on the surface of the PAS film 113 by coating. Then, the organic insulating film 114 is formed by photolithography, and the contact hole 118 is formed above the semiconductor layer 117 in the region for forming the contact hole portion 103, and the organic insulating film 114 is removed from the region for forming the terminal portion 104.

Next, as shown in FIG. 30, part of the PAS film 113 exposed from the organic insulating film 114 is etched to be removed. Next, as shown in FIG. 31, part of the aluminum film 112 exposed from the organic insulating film 114 is etched to be removed. Then, as shown in FIG. 32, photolithography and etching are performed with respect to the surface of the organic insulating film 114, and the ITO film formed in the region for forming the terminal portion 104, thereby forming the pixel electrode 115 and the upper terminal layer 123. In this way, the TFT substrate 100 is fabricated.

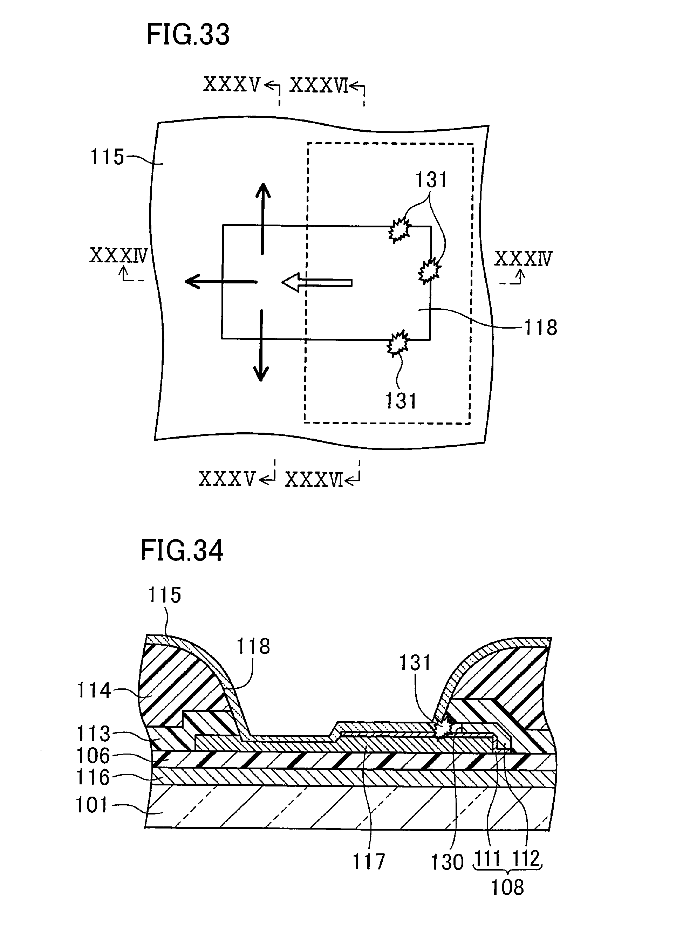

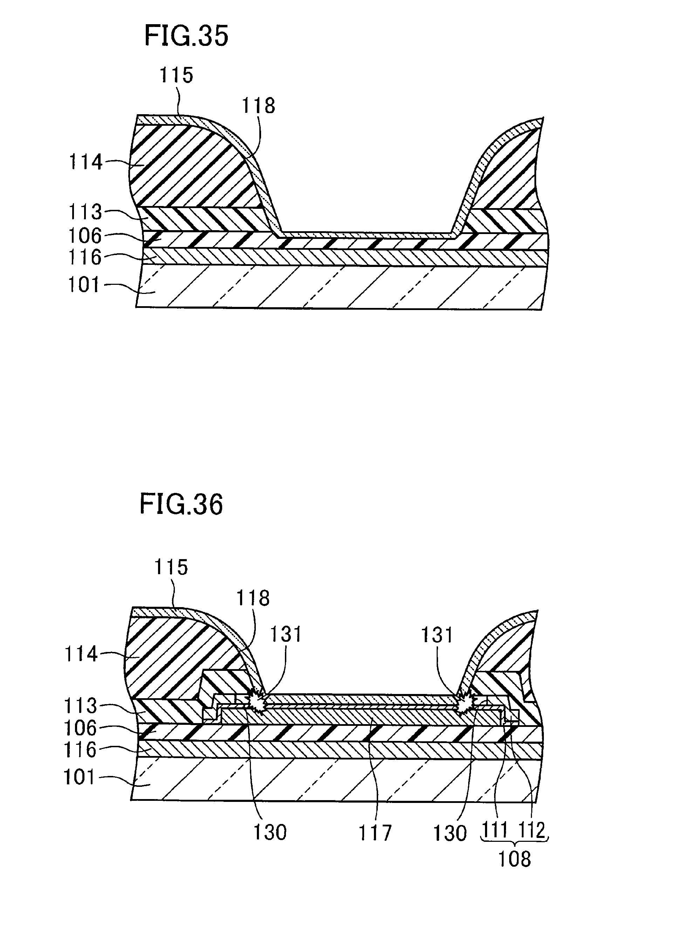

The etching process in FIG. 31 will be described with reference to FIGS. 33-36. FIG. 33 is a plan view for schematically showing the contact hole portion 103 in FIG. 31. FIG. 34 is a cross-sectional view taken along the line XXXIV-XXXIV of FIG. 33. FIG. 35 is a cross-sectional view taken along the line XXXV-XXXV of FIG. 33. FIG. 36 is a cross-sectional view taken along the line XXXVI-XXXVI of FIG. 33.

An aluminum film or an aluminum alloy film including aluminum as a main component which is a low resistance metal material cannot reliably be in contact with a transparent conducting film (ITO) which is the pixel electrode 115, and therefore, in the etching step in FIG. 31, part of a low resistance metal film (the aluminum film 112) of the drain lead electrode 108 facing the inside of the contact hole 118 has to be removed by wet etching.

However, the wet etching is an isotropic etching process, and as shown in FIGS. 34 and 36, part of the aluminum film 112 is side etched (over etched) so as to retract under the interlayer insulating film (the PAS film 113), and a step 130 is formed. Such a step 130 has a problem where a disconnection portion 131 is likely to occur in the pixel electrode 115.

In the TFT substrate 100, the contact hole 118 is formed in a region in which the drain lead electrode 108 exists and a region in which the drain lead electrode 108 does not exist, and as shown in the left part of FIG. 34 and FIG. 35, disconnection does not occur in the pixel electrode 115 in the region in which the drain lead electrode 108 does not exists. As a result, it becomes possible to reliably connect the pixel electrode 115 and the drain lead electrode 108 together.

In this way, according to the above fabrication method, as shown in FIG. 37, the photolithography is performed 6 times, the film formation step is performed 5 times, the etching step is performed 7 times, and the separation step is performed 5 times.

However, in the TFT substrate 100, in order to connect the pixel electrode 115 and the drain lead electrode 108 together, it is necessary to arrange, in the contact hole 118, not only the region in which the drain lead electrode 108 exists but also the region in which the drain lead electrode 108 does not exist, and as a result, the contact hole 118 has to have a relatively larger diameter.

In a region in which the contact hole 118 is formed, light shielding by the auxiliary capacitor line 116 is needed in view of decreasing in display quality, and the larger size of the contact hole causes a decrease in an aperture ratio of a pixel, as stated above.

In view of the foregoing, the present invention has been achieved. It is an object of the present invention to reliably connect an electrode portion having a low resistance metal film and a pixel electrode together, while improving an aperture ratio.

### SOLUTION TO THE PROBLEM

In order to attain the above object, a method of fabricating a display device according to the present invention is directed to a method of a display device including a first substrate having a plurality of switching elements, and a plurality of electrode portions each of which is electrically connected to a corresponding one of the switching elements, and a second substrate provided to face the first substrate, the electrode portion having a first conducting film, and a second conducting film stacked on the first conducting film and made of a low resistance metal film whose electrical resistance is lower than that of the first conducting film.

The fabrication method includes the steps of: forming a multilayer structure in which the first conducting film and the second conducting film are stacked in this order on a substrate constituting the first substrate; removing part of the second conducting film and forming a contact region in which the first conducting film does not overlap with the second conducting film, thereby forming the electrode portions from the multilayer structure; forming a planarized film made of a photosensitive material on the substrate on which the electrode portion is formed to cover the electrode portion, thereby forming a contact hole located inside the contact region and passing through the planarized film; and forming a pixel electrode on a surface of the planarized film to cover part of the first conducting film located inside the contact hole and exposed from the planarized film.

The display device according to the present invention is directed to a display device including a first substrate having a plurality of switching elements, and a plurality of electrode portions each of which is electrically connected to a corresponding one of the switching elements, and a second substrate provided to face the first substrate, the electrode portion having a first conducting film, and a second conducting film stacked on the first conducting film and is made of a low resistance metal film whose electrical resistance is lower than that of the first conducting film.

The electrode portion has a contact region in which the first conducting film does not overlap with the second conducting film, and the planarized film covering the electrode portion and made of the photosensitive material is formed on the first substrate, and the contact hole passing through the planarized film is formed inside the contact region, and the pixel electrode is formed on the surface of the planarized film so as to cover part of the first conducting film located inside the contact hole and exposed from the planarized film, and the inner circumferential surface of the contact hole is formed to be smooth without steps.

### -Effects-

The display device fabricated by the fabrication method according to the present invention includes the first substrate, and the second substrate provided to face the first substrate. The first substrate includes the plurality of the switching elements, and the plurality of the electrode portions each of which is connected to a corresponding one of the switching elements. The electrode portion has the first conducting film and the second conducting film stacked on the first conducting film, and made of a low resistance metal film whose electrical resistance is lower than that of the first conducting film. As the first conducting film, for example, titanium can be applied, and as the second conducting film, for example, an aluminum film or an aluminum alloy film including aluminum as a main component can be applied.

When the display device is fabricated, first, the multilayer structure in which the first conducting film and the second conducting film are stacked in this order is formed on the first substrate. Next, part of the second conducting film is removed, and the contact region in which the first conducting film does not overlap with the second conducting film is formed, thereby forming the electrode portion from the multilayer structure.

Next, the planarized film made of the photosensitive material is formed on the substrate on which the electrode portion is formed to cover the electrode portion, thereby forming the contact hole located inside the contact region and passing through the planarized film. Next, the pixel electrode is formed on the surface of the planarized film to cover part of the first conducting film located inside the contact hole and exposed from the planarized film.

This formation allows the pixel electrode to be directly electrically connected to the first conducting film of the electrode portion in the inside of the contact region. Therefore, it is unnecessary to form a contact hole in a broad area ranging from the region where the drain electrode 10 is formed to the region where the drain electrode 10 is not formed with a purpose of electrically connecting the pixel electrode 14 and the drain electrode 10 together as done in the conventional art, thereby making it possible to reduce the region for forming the contact hole and improve an aperture ratio.

### ADVANTAGES OF THE INVENTION

According to the present invention, since the electrode portion has the second conducting film made of the low resistance metal material, a line resistance of the electrode portion can be reduced, and since the pixel electrode can be directly electrically connected to the first conducting film of the electrode portion in the inside of the contact region, the electrode portion and the pixel electrode are reliably connected together while an aperture ratio can be improved.

### BRIEF DESCRIPTION OF THE DRAWINGS

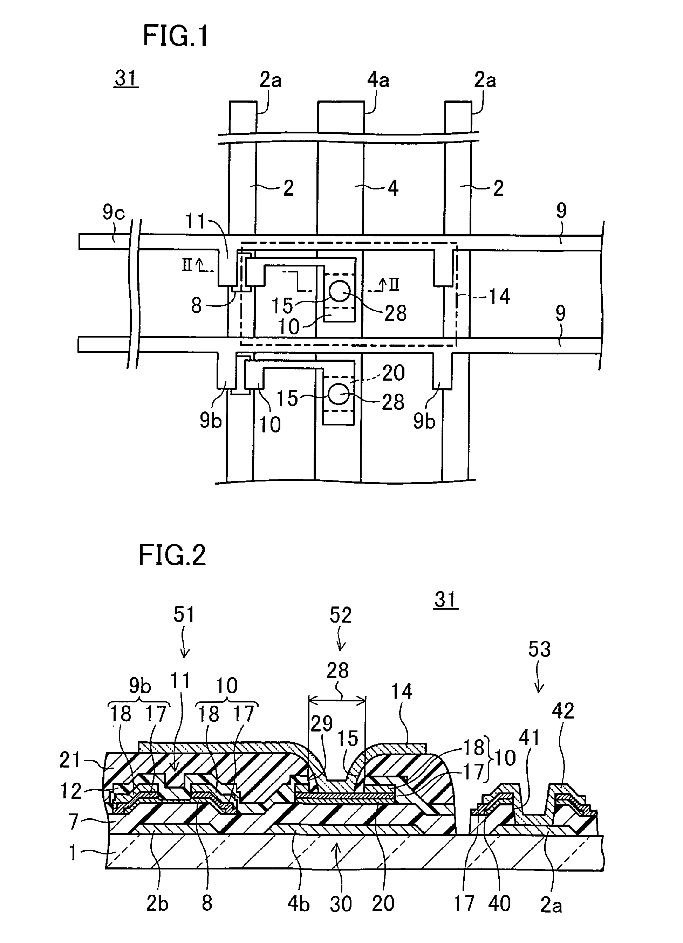

[FIG. 1] FIG. 1 is an enlarged plan view showing part of a liquid crystal display device in a first embodiment.
[FIG. 2] FIG. 2 is a cross-sectional view including a cross section taken along the line II-II of FIG. 1.

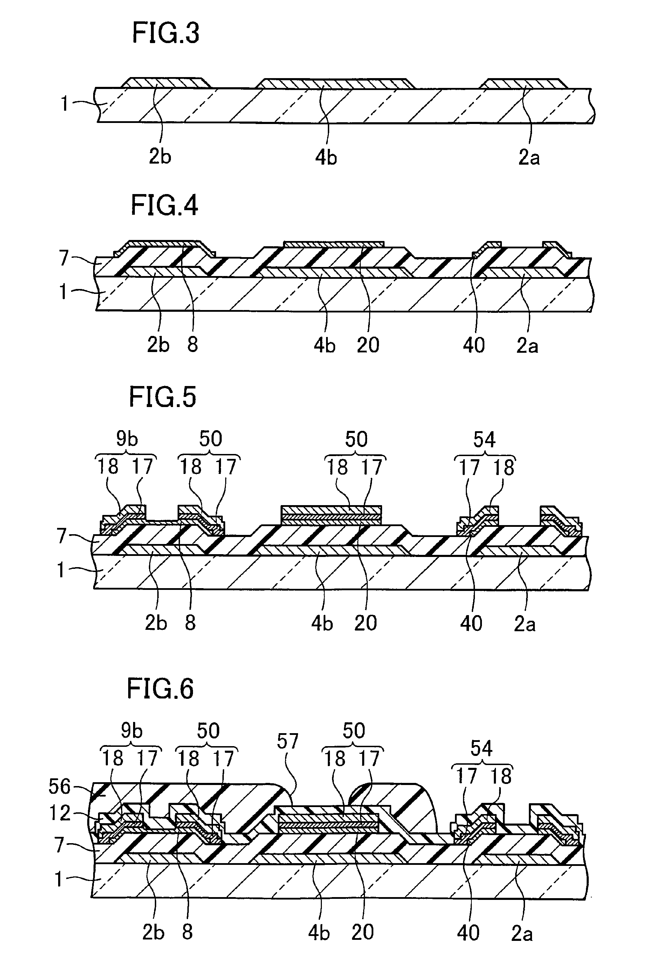

[FIG. 3] FIG. 3 is a cross-sectional view showing gate electrodes, and etc., formed on an insulating substrate in a fabrication step in the first embodiment.
[FIG. 4] FIG. 4 is a cross-sectional view showing a semiconductor layer formed on a gate insulating film in the fabrication step in the first embodiment.
[FIG. 5] FIG. 5 is a cross-sectional view showing a first multilayer structure and a second multilayer structure formed on the gate insulating film in the fabrication step in the first embodiment.
[FIG. 6] FIG. 6 is a cross-sectional view showing a mask pattern of a resist having an opening therein in the fabrication step in the first embodiment.

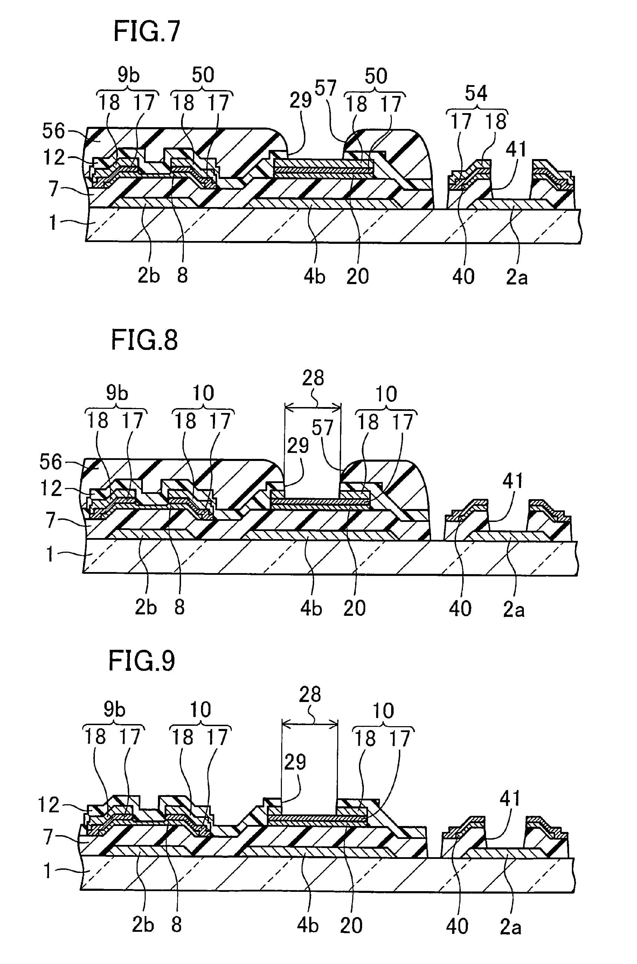

[FIG. 7] FIG. 7 is a cross-sectional view showing a PAS film having an opening therein in the fabrication step in the first embodiment.
[FIG. 8] FIG. 8 is a cross-sectional view showing a drain electrode formed by partially removing part of an aluminum alloy film in the fabrication step in the first embodiment.
[FIG. 9] FIG. 9 is a cross-sectional view showing a substrate in which the mask pattern of the resist is removed in the fabrication step in the first embodiment.

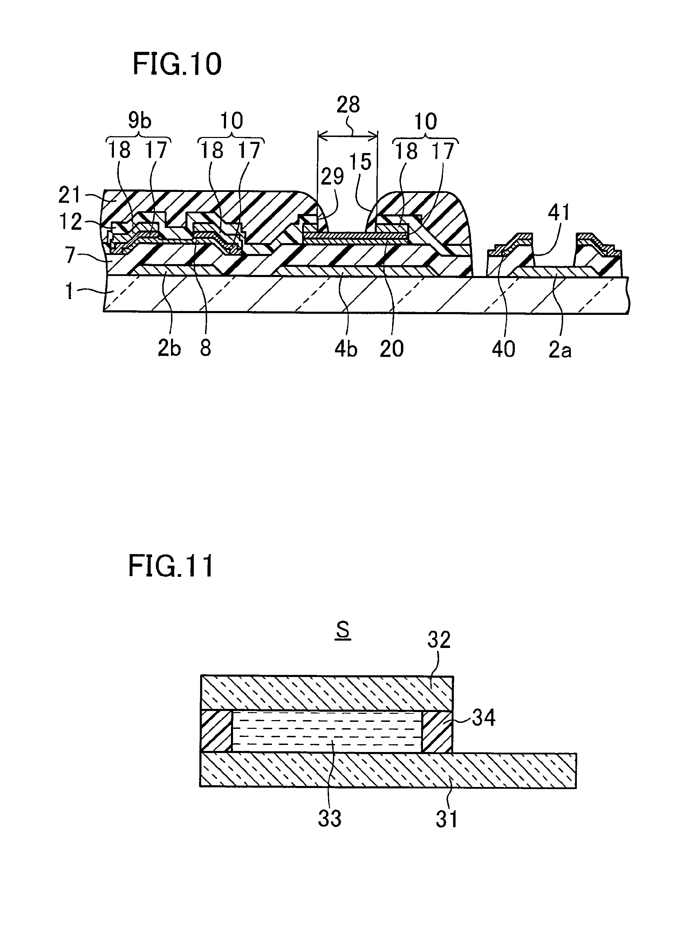

[FIG. 10] FIG. 10 is a cross-sectional view showing a planarized film having a contact hole therein in the fabrication step in the first embodiment.
[FIG. 11] FIG. 11 is a cross-sectional view showing a schematic structure of the liquid crystal display device.

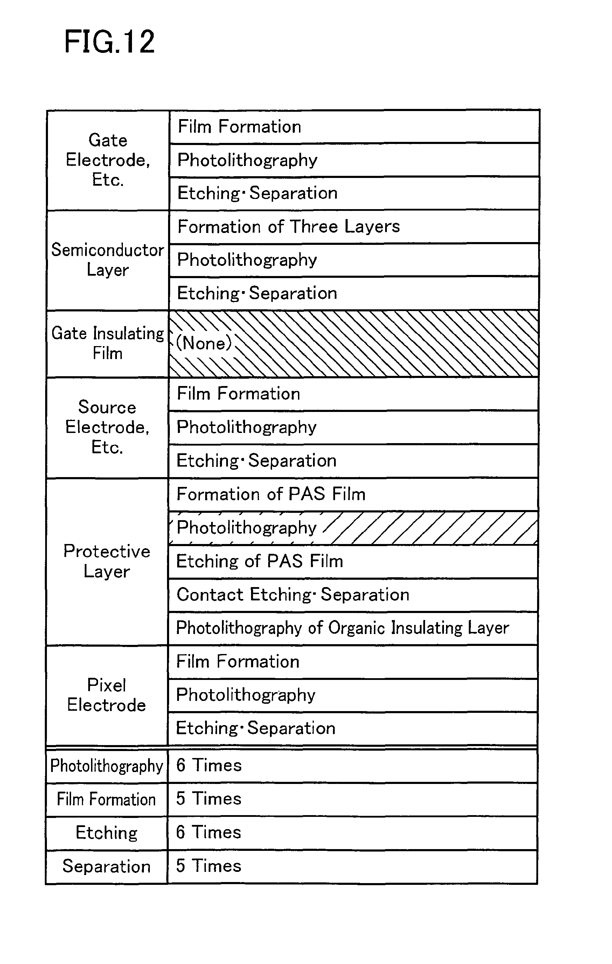

[FIG. 12] FIG. 12 is a table explaining the steps of fabricating a TFT substrate in the first embodiment.

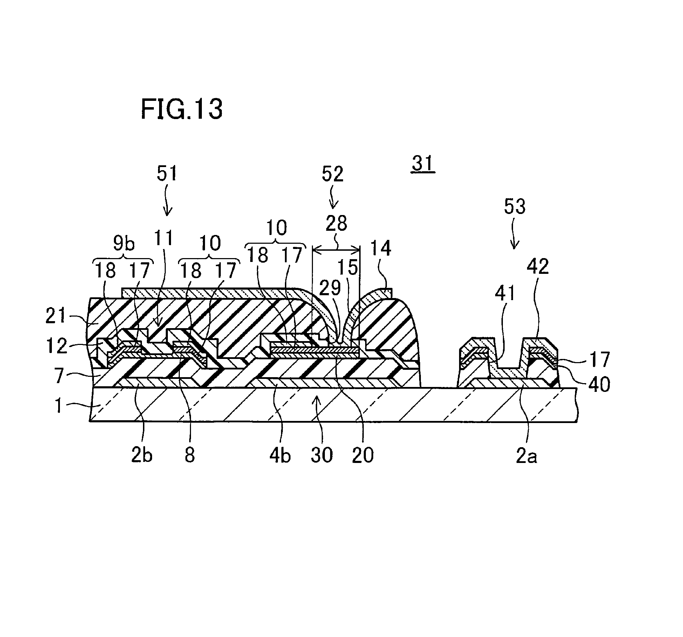

[FIG. 13] FIG. 13 is a cross-sectional view showing a structure of a TFT substrate in a second embodiment.

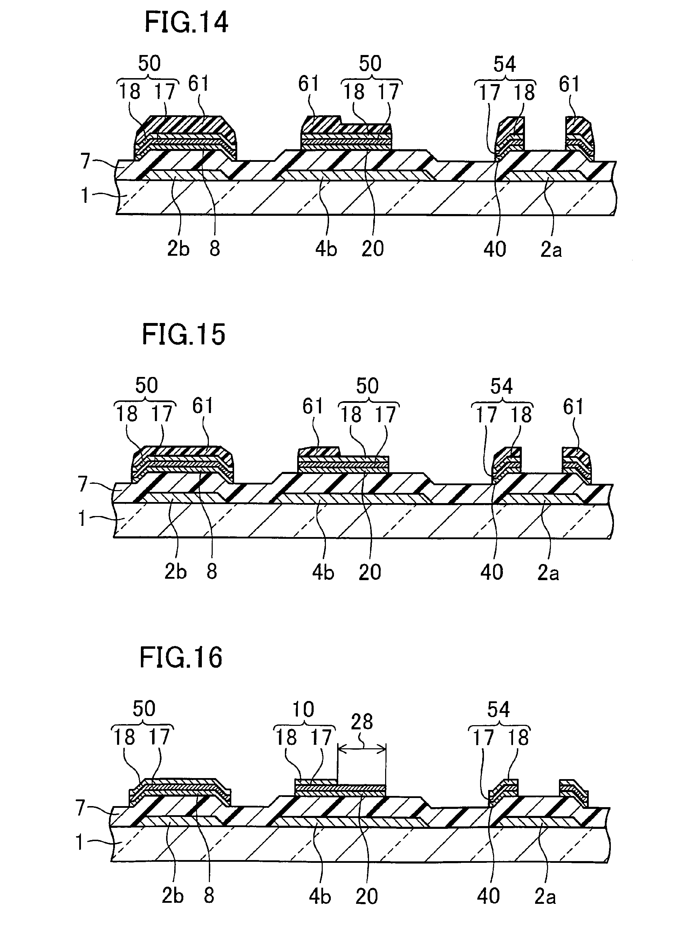

[FIG. 14] FIG. 14 is a cross-sectional view showing a resist formed for half etching in a fabrication step in the second embodiment.
[FIG. 15] FIG. 15 is a cross-sectional view showing a resist whose thickness is reduced in the fabrication step in the second embodiment.
[FIG. 16] FIG. 16 is a cross-sectional view showing a first multilayer structure, and etc., which are half etched in the fabrication step in the second embodiment.

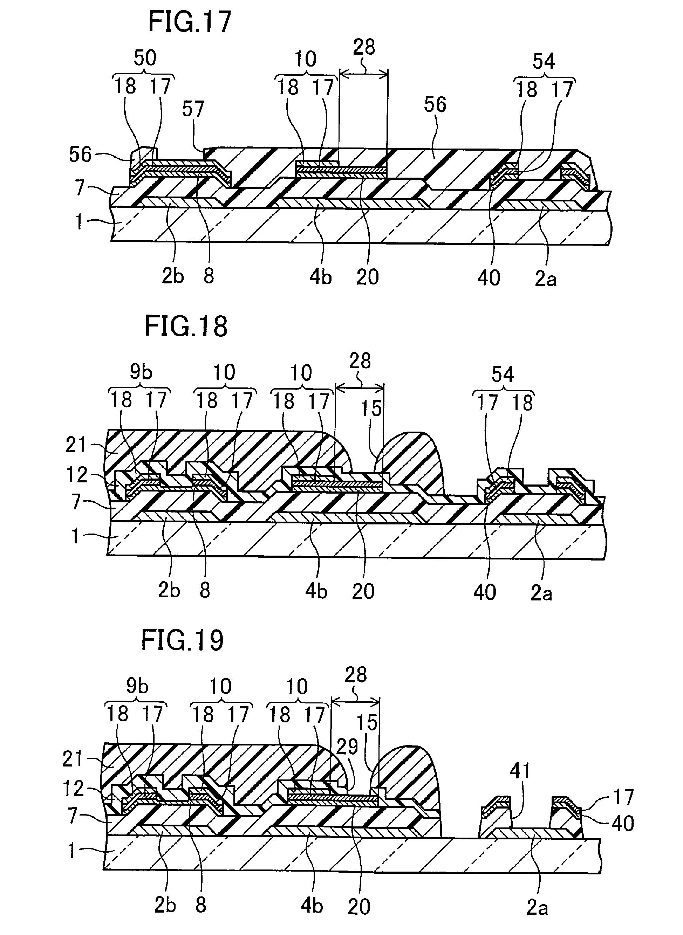

[FIG. 17] FIG. 17 is a cross-sectional view showing a mask pattern of a resist having an opening therein in the fabrication step in the second embodiment.
[FIG. 18] FIG. 18 is a cross-sectional view showing a planarized film having a contact hole therein in the fabrication step in the second embodiment.
[FIG. 19] FIG. 19 is a cross-sectional view showing a PAS film having an opening therein in the fabrication step in the second embodiment.

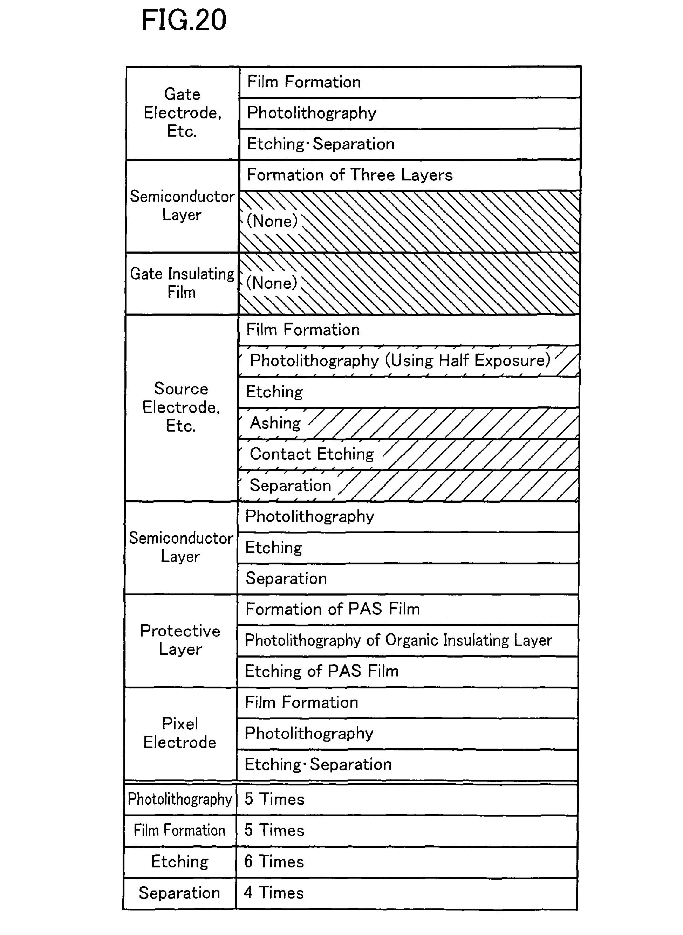

[FIG. 20] FIG. 20 is a table explaining the steps of fabricating the TFT substrate in the second embodiment.

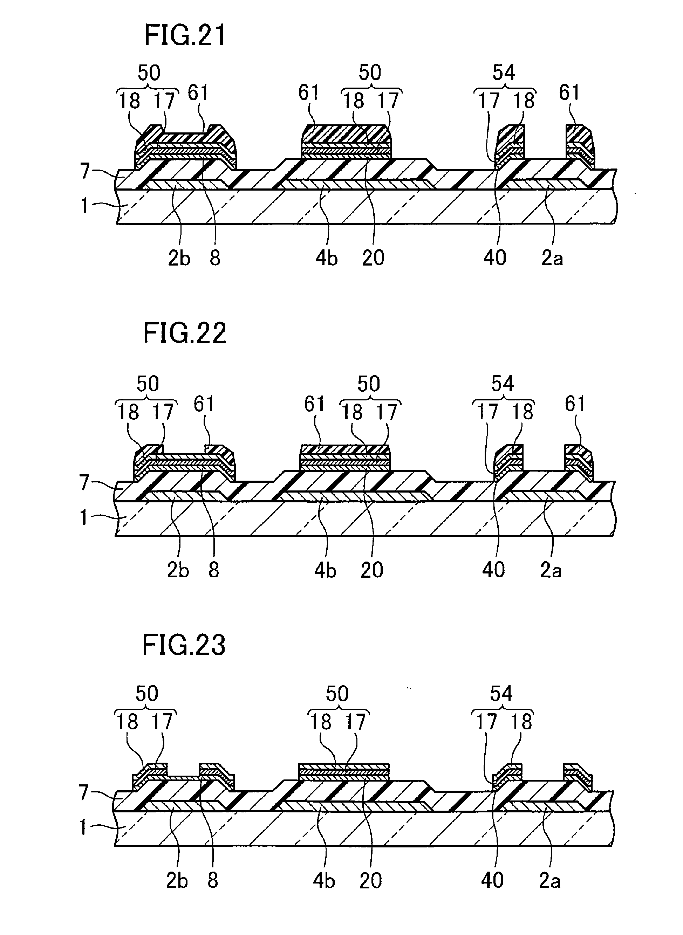

[FIG. 21] FIG. 21 is a cross-sectional view showing a resist formed for half etching in a fabrication step in a third embodiment.
[FIG. 22] FIG. 22 is a cross-sectional view showing a resist whose thickness is reduced in the fabrication step in the third embodiment.
[FIG. 23] FIG. 23 is a cross-sectional view showing a first multilayer structure, and etc., which are half etched in the fabrication step in the third embodiment.

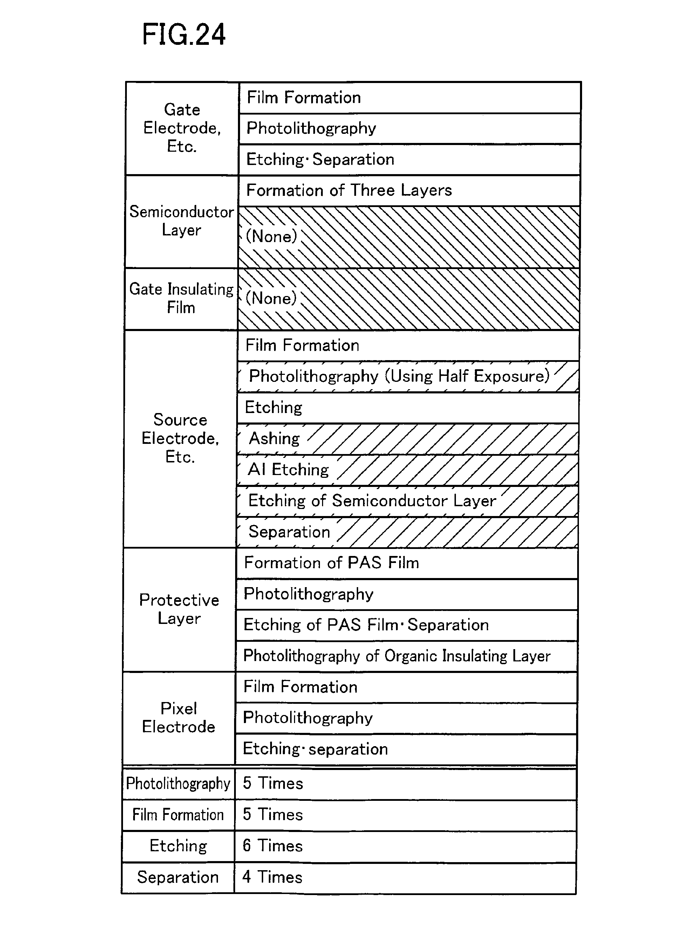

[FIG. 24] FIG. 24 is a table explaining the steps of fabricating a TFT substrate in the third embodiment.
[FIG. 25] FIG. 25 is a cross-sectional view showing gate electrodes, and etc., formed on an insulating substrate in a fabrication step in a related art of the present invention.
[FIG. 26] FIG. 26 is a cross-sectional view showing a semiconductor layer formed on a gate insulating film in the fabrication step in the related art of the present invention.
[FIG. 27] FIG. 27 is a cross-sectional view showing a contact hole formed in the gate insulating film in the fabrication step in the related art of the present invention.
[FIG. 28] FIG. 28 is a cross-sectional view showing a drain lead electrode and a source lead electrode formed on the gate insulating film in the fabrication step in the related art of the present invention.
[FIG. 29] FIG. 29 is a cross-sectional view showing an organic insulating film having a contact hole therein in the fabrication step in the related art of the present invention.
[FIG. 30] FIG. 30 is a cross-sectional view showing a state in which part of a PAS film exposed from the organic insulating film is removed from the organic insulating film in the fabrication step in the related art of the present invention.
[FIG. 31] FIG. 31 is a cross-sectional view showing a state in which part of an aluminum alloy film exposed from the organic insulating film is removed from the organic insulating film in the fabrication step in the related art of the present invention.
[FIG. 32] FIG. 32 is an enlarged cross-sectional view showing part of a TFT substrate in the related art of the present invention.
[FIG. 33] FIG. 33 is a schematic plan view showing a contact hole portion in FIG. 31.
[FIG. 34] FIG. 34 is a cross-sectional view taken along the line XXXIV-XXXIV of FIG. 33.
[FIG. 35] FIG. 35 is a cross-sectional view taken along the line XXXV-XXXV of FIG. 33.
[FIG. 36] FIG. 36 is a cross-sectional view taken along the line XXXVI-XXXVI of FIG. 33.
[FIG. 37] FIG. 37 is a table explaining the steps of fabricating a TFT substrate in the related art of the present invention.

### DESCRIPTION OF EMBODIMENTS

Embodiments of the present invention will be described in detail hereinafter with reference to the drawings. The present invention is not limited to the following embodiments.

### [First Embodiment of the Invention]

FIGS. 1-12 show a first embodiment of the present invention.

FIG. 1 is an enlarged plan view showing part of a liquid crystal display device S in a first embodiment. FIG. 2 is a cross-sectional view including a cross section taken along the line II-II of FIG. 1. FIGS. 3-10 are cross-sectional views showing the steps of fabricating the liquid crystal display device S. FIG. 11 is a cross-sectional view showing a schematic structure of the liquid crystal display device S in the first embodiment. FIG. 12 is explaining the steps of fabricating a TFT substrate in the first embodiment.

In the first embodiment, the liquid crystal display device S will be described as an example of a display device.

The liquid crystal display device S includes, as shown in FIG. 11, a TFT substrate 31 serving as an active matrix substrate which is a first substrate, a counter substrate 32 serving as a second substrate facing the TFT substrate 31, and a liquid crystal layer 33 provided between the TFT substrate 31 and the counter substrate 32.

The liquid crystal display device S includes a display region (not shown) and a non-display region (not shown) formed in a picture-frame and provided in the periphery of the display region. In the display region, a plurality of pixels (not shown) are provided in a matrix.

In the counter substrate 32, a color filter and a common electrode, etc. (not shown) are formed. The liquid crystal layer 33 is sealed by a sealing member 34 provided between the TFT substrate 31 and the counter substrate 32.

The TFT substrate 31 has a transparent insulating substrate 1, such as a glass substrate, etc., constituting the TFT substrate 31. On the insulating substrate 1, as shown in FIG. 1, a plurality of source lines 9 extending in parallel to each other, and a plurality of gate lines 2 extending in a direction perpendicular to the source lines 9 are formed. In other words, a line group including the gate lines 2 and the source lines 9 is formed in a lattice form as a whole. For example, the pixels are formed in the lattice region. In each of the pixels, a TFT (Thin-Film Transistor) 11 as a switching element, and a pixel electrode 14 connected to the TFT are formed. The TFT 11 is connected to the gate lines 2 and the source lines 9. The gate line 2 has a gate electrode 2b in a region for forming the TFT 11. An auxiliary capacitor line 4 is formed between adjoining ones of the gate lines 2. In an end portion of the auxiliary capacitor line 4, an auxiliary capacitor signal input terminal 4a is formed.

The TFT substrate 31, as shown in FIG. 2, has a TFT portion 51 in which the TFT 11 is formed, a contact hole portion 52 in which a contact hole 15 is formed, and a terminal portion 53 to which gate signals, etc. are input.

### (TFT Portion 51)

The TFT portion 51 has the gate electrode 2b formed on the insulating substrate 1, a gate insulating film 7 covering the gate electrode 2b, a TFT portion island-shaped semiconductor layer 8 formed on the gate insulating film 7, and a drain electrode 10 and a source electrode 9b formed on the surface of the TFT portion island-shaped semiconductor layer 8.

The gate insulating film 7 is made of, e.g., SiNx (silicon nitride). The TFT portion island-shaped semiconductor layer 8, the detailed illustration of which is omitted, has an ia-Si film made of intrinsic amorphous silicon, and an n+a-Si film, which is an ohmic contact layer, stacked on the ia-Si film, and is formed to have a thickness of approximately 130 nm as a whole.

Each of the drain electrode 10 and the source electrode 9b constitutes an electrode portion electrically connected to the TFT 11, and includes a titanium film 17 serving as a first conducting film, and an aluminum film 18, serving as a second conducting film, stacked on the titanium film 17, and made of a low resistance metal film whose electrical resistance is lower than that of the titanium film 17. The thickness of the titanium film 17 is, e.g., approximately 30 nm, and the thickness of the aluminum film 18 is, e.g., approximately 100 nm.

The second conducting film 18 can be made of the aluminum alloy film including aluminum as a main component other than the aluminum film. As a metal material whose electrical resistance is lower than that of a metal material constituting the titanium film 17, for example, Cu, Al, Ti, W, Ta, Hf, Au, Ag, Pt, I·r, Ru, TiN, WN, IrO₂, or RuO₂, etc., can be applied to the second conducting film 18.

As shown in FIG. 1, the source electrode 9b is formed in FIG. 1 as part of the source line 9 formed on the gate insulating film 7. In the end portion of the source line 9, a source signal input terminal 9c is formed. The drain electrode 10 is formed in the TFT portion 51 and the contact hole portion 52.

The TFT portion island-shaped semiconductor layer 8, the drain electrode 10, and the source electrode 9b are covered by a passivation film (hereinafter referred to as the PAS film) 12 serving as a protective film. The PAS film 12 is made of an inorganic film, such as SiNx, etc. The PAS film 12 has an uneven surface due to shapes of the source electrode 9b, the drain electrode 10, and etc.

Besides, a planarized film 21 as an organic insulating film made of a photosensitive material is stacked on the surface of the PAS film 12. The planarized film 21 is made of, e.g., an acrylic resin including a photosensitizer. The surface of the planarized film 21 is planarized, and on the surface thereof, the pixel electrode 14 made of a transparent conducting film, such as ITO, etc., is formed.

### (Contact Hole Portion 52)

The contact hole portion 52 has an auxiliary capacitor electrode 4b formed on the insulating substrate 1, the gate insulating film 7 covering the auxiliary capacitor electrode 4b, a hole portion island-shaped semiconductor layer 20 formed on the surface of the gate insulating film 7, and the drain electrode 10 covering the hole portion island-shaped semiconductor layer 20.

The hole portion island-shaped semiconductor layer 20 is made of the same material as the TFT portion island-shaped semiconductor layer 8 and is formed to have the same thickness as the TFT portion island-shaped semiconductor layer 8. The drain electrode 10 of the contact hole portion 52 is integrally formed with the drain electrode 10 of the TFT portion 51. The drain electrode 10 has, in a region facing the auxiliary capacitor electrode 4b, a contact region 28 in which the titanium film 17 does not overlap with the aluminum film 18. In other words, the contact region 28 is formed as a region which is formed on the titanium film 17 and is not covered by the aluminum film 18.

The PAS film 12 is formed on the auxiliary capacitor electrode 4b to directly cover part of the drain electrode 10. The PAS film 12 has an opening 29 formed in a region in which the contact region 28 is formed. In other words, the opening 29 in the embodiment have the same shape as that of the contact region 28 when viewed in plan.

In the TFT substrate 31, the planarized film 21 stacked on the PAS film 12 and covering the drain electrode 10 is formed. The contact hole 15 passing through the planarized film 21 is formed inside the contact region 28. The contact hole 15 is formed inside the contact region 28 and the opening 29 of the PAS film 12. The inner circumferential surface of the contact hole 15 is formed to be smooth without steps.

On the surface of the planarized film 21, the pixel electrode 14 is formed so as to cover part of the titanium film 17 exposed from the planarized film 21 in the inside of the contact hole 15. In other words, the drain electrode 10 is directly connected to the pixel electrode 14 in the titanium film 17 of the contact region 28.

In this way, an auxiliary capacitor 30 for keeping an applied voltage on the pixel electrode 14 substantially constant is formed by the auxiliary capacitor electrode 4b and the drain electrode 10 facing each other. The auxiliary capacitor electrode 4b also serves as a light shielding film shielding a region in which the contact hole 15 is formed.

### (Terminal Portion 53)

The terminal portion 53 has a lower terminal layer 2a formed on the insulating substrate 1, the gate insulating film 7 covering the lower terminal layer 2a, a terminal portion island-shaped semiconductor layer 40 formed on the surface of the gate insulating film 7, and the titanium film 17 formed to cover the terminal portion island-shaped semiconductor layer 40.

The lower terminal layer 2a is formed in the end portion of the gate line 2. The terminal portion island-shaped semiconductor layer 40 is made of the same material as that of the TFT portion island-shaped semiconductor layer 8, and is formed to have the same thickness as that of TFT portion island-shaped semiconductor layer 8. The titanium film 17 is formed in the same step as that of forming the titanium film 17 constituting the drain electrode 10. A contact hole 41 passing through the titanium film 17, the terminal portion island-shaped semiconductor layer 40, and the gate insulating film 7 is formed on the lower terminal layer 2a.

An upper terminal layer 42 connected to the lower terminal layer 2a through the contact hole 41 is formed on the surface of the titanium film 17. In other words, the upper terminal layer 42 is connected to the lower terminal layer 2a in the inside of the contact hole 41. The upper terminal layer 42 is made of ITO, which is the same material as that of the pixel electrode 14.

### -Fabrication Method-

Next, a method for fabricating the liquid crystal display device S will be described with reference to FIGS. 2-10 and FIG. 12.

### (Formation Step of Gate Line, and Etc.)

First, as shown in FIG. 3, a metal thin film, such as a titanium film, or an aluminum alloy film, etc., is formed on the insulating substrate 1, such as a cleaned glass substrate, etc., by a sputtering method, etc. Next, a resist pattern is formed on the metal thin film by, e.g., a photolithography method, etc., through a resist coating step, an exposure step, and a development step, and then, the pattern is dry etched or wet etched. These steps form the gate electrode 2b, the gate line 2, the lower terminal layer 2a, the auxiliary capacitor electrode 4b, the auxiliary capacitor line 4, and the auxiliary capacitor signal input terminal 4a on the insulating substrate.

Next, as shown in FIG. 4, the gate insulating film 7 made of SiNx is formed on the whole surface of the insulating substrate 1 by a P-CVD method using SiH₄, NH₃, N₂ gas. Next, on the surface of the gate insulating film 7, an ia-Si film which is intrinsic amorphous silicon and an n+a-Si film of phosphorus (P) which is an ohmic contact layer is doped by a P-CVD method. At this time, SiH₄ or H₂ is used for the ia-Si film as a source gas. In contrast, SiH₄, or H₂ gas including 0.5% of PH₃ gas therein is used for the n+a-Si film.

Photolithography and etching are performed with respect to the ia-Si film and the n+a-Si film formed as stated above, thereby forming the TFT portion island-shaped semiconductor layer 8 to overlap with the gate electrode 2b through the gate insulating film 7. Simultaneously, the hole portion island-shaped semiconductor layer 20 is formed on the auxiliary capacitor electrode 4b, and the terminal portion island-shaped semiconductor layer 40 is formed on the lower terminal layer 2a. At this time, the terminal portion island-shaped semiconductor layer 40 is not formed in a region in which the contact hole 41 is to be formed in a subsequent step, and part of the gate insulating film 7 is exposed.

### (Multilayer Structure Formation Step)

Next, the titanium film 17 and the aluminum film 18 are formed in this order on the whole surface of the substrate by a sputtering method, etc. Then, as shown in FIG. 5, by photolithography and etching, the stacked film of the titanium film 17 and the aluminum film 18 forms the source electrode 9b, the source line 9, the source signal input terminal 9c, a first multilayer structure 50 serving as the drain electrode 10 later, and a second multilayer structure 54 constituting the terminal portion 53 later.

The first multilayer structure 50 has one end overlapping with the TFT portion island-shaped semiconductor layer 8, and the other end overlapping with the hole portion island-shaped semiconductor layer 20. The second multilayer structure 54 overlaps with the terminal portion island-shaped semiconductor layer 40, and is not formed in a region in which the contact hole 41 is to be formed in a subsequent step as well as the terminal portion island-shaped semiconductor layer 40, and part of the gate insulating film 7 is exposed.

### (Opening Formation Step)

Next, as shown in FIG. 6, the PAS film 12 serving as a protective film covering the source electrode 9b, the first multilayer structure 50, and the second multilayer structure 54 is formed. In other words, the PAS film 12 made of SiNx is formed on the whole surface of the substrate by a P-CVD method using SiH₄, NH₃, N₂ gas. The PAS film 12 is formed to have an uneven surface due to stepped surfaces of the source electrode 9b, the first multilayer structure 50, and etc. Other than SiNx, other inorganic films, e.g., SiO₂, etc. can be applied to the PAS film 12.

Subsequently, a mask pattern 56 made of a resist is formed on the surface of the PAS film 12 by a photolithography method. The mask pattern 56 has the opening 57 in the upper part of the first multilayer structure 50. A region in which the terminal portion 53 is formed is exposed from the mask pattern 56. In the opening 57, part of the PAS film 12 exposed from the mask pattern 56 is dry etched, thereby forming the opening 29 in the PAS film 12 so that part of the aluminum film 18 of the first multilayer structure 50 is exposed from the PAS film 12, as shown in FIG. 7. The dry etching at this time is performed by using a mixed gas of CF₄ and O₂ in a RIE (reactive ion etching) mode.

At the same time of forming the opening 29, the PAS film 12 having covered the aluminum film 18 and the gate insulating film 7 on the lower terminal layer 2a is removed. In addition, etching is performed to remove part of the gate insulating film 7 exposed from the aluminum film 18 on the lower terminal layer 2a to form the contact hole 41 in the gate insulating film 7.

At this time, since the aluminum films 18 of the first multilayer structure 50 and the aluminum films 18 of the second multilayer structure 54 function as an etch stopper, the opening 29 of the PAS film 12 and the contact hole 41 are simultaneously formed by one mask.

### (Electrode Portion Formation Step)

Subsequently, as shown in FIG. 8, part of the aluminum film 18 exposed from the mask pattern 56 in the opening 29 of the PAS film 12 is removed by wet etching, thereby exposing part of the titanium film 17 from the aluminum film 18. The titanium film 17 forms the contact region 28 not overlapping with the aluminum film 18, whereby the drain electrode 10 serving as an electrode portion is formed from the first multilayer structure 50. The aluminum film 18 exposed from the mask pattern 56 in the second multilayer structure 54 is also simultaneously etched, thereby removing the aluminum film 18 to expose the titanium film 17, as shown in FIG. 8.

At this time, part of the aluminum film 18 located in the side of the contact region 28 is side etched (over etched) so as to retract under the PAS film 18, and a step (not shown) can be formed.

### (Contact Hole Formation Step)

Next, as shown in FIG. 9, the resist of the mask pattern 56 is peeled off to be removed from a region on the insulating substrate 1. Then, the planarized film 21 made of an organic insulating film (acrylic resin) which is a photosensitive material is formed on the insulating substrate 1 so as to cover the drain electrode 10, etc. The planarized film 21 is formed by coating by a spin coating method, etc., so as to cover the PAS film 12 in which the opening 29 is formed.

Then, as shown in FIG. 10, the contact hole 15 passing through the planarized film 21 is formed inside the opening 29 of the PAS film 12 (thus, inside the contact region 28) by a photolithography method. This formation allows the titanium film 17 of the contact region 28 to be exposed inside the contact hole 15, and allows the inner side surface of the aluminum film 18 of the drain electrode 10 to be covered by the planarized film 21. In other words, the steps formed by the over etching of the aluminum film 18 are covered by the planarized film 21.

### (Pixel Electrode Formation Step)

Next, as shown in FIG. 2, the pixel electrode 14 is formed on the surface of the planarized film 21 so as to cover the titanium film 17 exposed from the planarized film 21 in the inside of the contact hole 15.

In other words, a transparent conducting film made of ITO, etc. is formed on the whole of the substrate by a sputtering method, etc. Subsequently, the film is patterned by photolithography and etching in a predetermined shape, thereby forming the pixel electrode 14 directly connected to the titanium film 17 of the drain electrode 10.

The conducting film constituting the pixel electrode 14 is not necessarily ITO, and for example, a non-transmissive conducting film such as Al, Ag, etc. may be used as a reflection type display electrode.

In this way, as shown in FIG. 12, according to the first embodiment, the photolithography is performed 6 times, the film formation step is performed 5 times, the etching step is performed 7 times, and the separation step is performed 5 times.

Then, an alignment film is formed so as to cover the pixel electrode 14, thereby fabricating the TFT substrate 31, though it is not shown. In contrast, the counter substrate 32 is fabricated by forming a counter electrode, a color filter, and etc., on another insulating substrate. The TFT substrate 31 and the counter substrate 32 are adhered to each other through the liquid crystal layer 33 and the sealing member 34, thereby manufacturing the liquid crystal display device S.

### -Advantage of First Embodiment-

Therefore, according to the first embodiment, the drain electrode 10 has the aluminum film 18 made of a low resistance metal material, thereby making it possible to reduce a line resistance of the drain electrode 10, and etc. Besides, since the planarized film 21 is formed after the drain electrode 10 having the contact region 28 is formed, the inner circumferential surface of the contact hole 15 passing through the planarized film 21 can be formed to be smooth without steps. Therefore, while the contact hole 15 is formed inside the contact region 28, disconnection of the pixel electrode 14 in the inner circumferential surface of the contact hole 15 is prevented, and the pixel electrode 14 and the drain electrode 10 can be reliably electrically connected together.

Furthermore, since it is unnecessary to form a contact hole in a broad area ranging from the region where the drain electrode 10 is formed to the region where the drain electrode 10 is not formed with a purpose of electrically connecting the pixel electrode 14 and the drain electrode 10 together as done in the conventional art, the region for forming the contact hole 15 in which display quality is descreased can be significantly reduced to approximately half the conventional region. As a result, the area of the light shielding film shielding the contact hole 15 can be reduced, thereby making it possible to significantly improve an aperture ratio of the liquid crystal display devices.

### [Second Embodiment]

FIGS. 13-20 show a second embodiment of the present invention.

FIG. 13 is a cross-sectional view showing a structure of a TFT substrate 31 in the second embodiment. FIGS. 14-19 are cross-sectional views showing the steps of fabricating the liquid crystal display device S. FIG. 20 is a table explaining the steps of fabricating the TFT substrate in the second embodiment. In the following embodiments, the same components as those shown in FIGS. 1-11 will be indicated by the same reference characters to omit detailed description thereof.

The liquid crystal display device S in the second embodiment has a structure of the contact hole portion 52 different from that of the TFT substrate 31 in the first embodiment. In other words, in the TFT substrate 31 in the first embodiment, the opening 29 of the PAS film 12 is provided outside the inner circumferential surface of the contact hole 15, whereas in the second embodiment, the opening 29 constitutes part of the inner circumferential surface of the contact hole 15.

In the second embodiment, the opening 29 of the PAS film 12 is formed to be smaller than the contact region 28 when viewed in plan. The opening 29 of the PAS film 12 in the second embodiment is not formed on the aluminum film 18 like the first embodiment, but is formed on the titanium film 17.

### -Fabrication method-

Next, a method for fabricating the liquid crystal display device S will be described with reference to FIGS. 13-20.

### (Formation Step of Gate Line, and Etc.)

First, as well as the first embodiment, the gate electrode 2b, the gate line 2, the lower terminal layer 2a, the auxiliary capacitor electrode 4b, the auxiliary capacitor line 4, and the auxiliary capacitor signal input terminal 4a are formed on the insulating substrate 1. Subsequently, the gate insulating film 7 made of SiNx is formed on the whole surface of the insulating substrate 1. Next, on the surface of the gate insulating film 7, the TFT portion island-shaped semiconductor layer 8, the hole portion island-shaped semiconductor layer 20 and the terminal portion island-shaped semiconductor layer 40 are formed.

### (Multilayer Structure Formation Step)

Next, after the titanium film 17 and the aluminum film 18 are formed in this order on the whole surface of the substrate by a sputtering method, etc., as shown in FIG. 14, by photolithography and etching, the stacked film of the titanium film 17 and the aluminum film 18 forms the source electrode 9b, the source line 9, the source signal input terminal 9c, the first multilayer structure 50 serving as the drain electrode 10 later, and the second multilayer structure 54 constituting the terminal portion 53 later. As well as the terminal portion island-shaped semiconductor layer 40, the second multilayer structure 54 is not formed in a region in which the contact hole 41 is to be formed in a subsequent step, and part of the gate insulating film 7 is exposed.

### (Electrode Portion Formation Step)

Next, the resist coated on the whole of the substrate is half etched, thereby forming a resist pattern 61 on each of the first multilayer structure 50 and the second multilayer structure 54, the resist pattern 61 located on the first multilayer structure 50 having a thickness different from that located on the second multilayer structure 54, as shown in FIG. 14. The resist pattern 61 located on the gate electrode 2b has a relatively thicker thickness. The resist pattern 61 located on the auxiliary capacitor electrode 4b has the left part thicker than the right part in FIG. 14. The resist pattern 61 located on the lower terminal layer 4b is formed to have a thick thickness which is approximately equal to that of the resist pattern 61 located on the gate electrode 2b.

Subsequently, as shown in FIGS. 15 and 16, an ashing process with respect to the resist pattern 61, and an etching process with respect to the first multilayer structure 50 and the second multilayer structure 54 are repeatedly performed, thereby etching and removing part of the aluminum film 18 of the first multilayer structure 50 (part of the aluminum film 18 exposed from the resist pattern 61) on the auxiliary capacitor electrode 4b. Then, the resist pattern 61 is removed by separation. The contact region 28 in which the titanium film 17 does not overlap with the aluminum film 18 is formed in the drain electrode 10 on the auxiliary capacitor electrode 4b.

Next, as shown in FIG. 17, the mask pattern 56 made of a resist is formed on the surface of the gate insulating film 7 by a photolithography method so as to cover the drain electrode 10. The mask pattern 56 has the opening 57 in the upper part of the gate electrode 2b. Next, part of the first multilayer structure 50 exposed from the mask pattern 56 is etched, thereby removing part of the aluminum film 18 and the titanium film 17. In this way, the source electrode 9b and the drain electrode 10 are formed.

### (Contact Hole Formation Step)

Next, as well as the first embodiment, the PAS film 12 serving as a protective film covering the source electrode 9b, the drain electrode 10, and the lower terminal layer 2a is formed by a P-CVD method. Subsequently, the planarized film 21 made of an organic insulating film which is a photosensitive material is formed by coating by a spin coating method, etc. Then, as shown in FIG. 18, the contact hole 15 passing through the planarized film 21 is formed inside the contact region 28 by a photolithography method. This formation allows part of the PAS film 12 to be exposed inside the contact hole 15. The region in which the terminal portion 53 is formed is exposed from the planarized film 21.

### (Opening Formation Step)

Subsequently, part of the PAS film 12 exposed in the contact hole 15 is dry etched. With the dry etching, as shown in FIG. 19, the opening 29 is formed in the PAS film 12 so that part of the titanium film 17 of the drain electrode 10 is exposed from the PAS film 12. The dry etching at this time is performed by using a mixed gas of CF₄ and O₂ in a RIE (reactive ion etching) mode.

At the same time of forming the opening 29, the PAS film 12 having covered the aluminum film 18 and the gate insulating film 7 on the lower terminal layer 2a is removed. In addition, etching is performed to remove part of the gate insulating film 7 exposed from the aluminum film 18 on the lower terminal layer 2a to form contact hole 41 in the gate insulating film 7.

At this time, since the titanium film 17 of the drain electrode 10 and the titanium film 17 on the lower terminal layer 2a function as an etch stopper, the opening 29 of the PAS film 12 and the contact hole 41 are simultaneously formed by one mask.

### (Pixel Electrode Formation Step)

Next, as shown in FIG. 13, the pixel electrode 14 on the surface of the planarized film 21 is formed so as to cover the titanium film 17 exposed from planarized film 21 in the inside of the contact hole 15.

In other words, a transparent conducting film made of ITO, etc. is formed on the whole of the substrate by a sputtering method, etc. Subsequently, the film is patterned by photolithography and etching to have a predetermined shape, thereby forming the pixel electrode 14 directly connected to the titanium film 17 of the drain electrode 10.

In this way, as shown in FIG. 20, according to the second embodiment, the photolithography is performed 5 times, the film formation step is performed 6 times, the etching step is performed 7 times, and the separation step is performed 4 times.

Then, the TFT substrate 31 fabricated by further forming an alignment film, and the counter substrate 32 fabricated by forming a counter electrode, a color filter, and etc. on another insulating substrate are adhered to each other through the liquid crystal layer 33 and the sealing member 34, thereby manufacturing the liquid crystal display device S.

### -Advantage of Second Embodiment-

Therefore, according to the second embodiment, as well as the first embodiment, a line resistance of the drain electrode 10, and etc., can be reduced, and since the planarized film 21 is formed after the drain electrode 10 having the contact region 28, the contact hole 15 can be formed so that the inner circumferential surface of the planarized film 21 and the inner circumferential surface of the opening 29 of the PAS film 12 form a continuous smooth surface. The inner side surface of the aluminum film 18 of the drain electrode 10 on the auxiliary capacitor electrode 4b, thereby making it possible not to form steps in the inner circumferential surface of the contact hole 15. Therefore, while the contact hole 15 is formed inside the contact region 28, disconnection of the pixel electrode 14 in the inner circumferential surface of the contact hole 15 is prevented, and the pixel electrode 14 and the drain electrode 10 can be reliably electrically connected together.

Furthermore, since the region for forming the contact hole 15 in which display quality is decreased can be significantly reduced, the area of the light shielding film shielding the contact hole 15 can also be reduced, thereby making it possible to significantly improve an aperture ratio of the liquid crystal display device S.

In addition, after the drain electrode 10 is formed in advance by half etching, the opening 29 of the PAS film 12 is formed, thereby making it possible to reduce the number of the masks to reduce fabrication costs.

### [Third Embodiment]

FIGS. 21-24 show a third embodiment of the present invention.

FIGS. 21-23 are cross-sectional views showing steps for fabricating a liquid crystal display device S. FIG. 24 is a table explaining the steps of fabricating a TFT substrate in the third embodiment.

The third embodiment is configured such that the first multilayer structure 50, and etc., are half etched in the fabrication method of the first embodiment.

In other words, in the multilayer structure formation step, first, the titanium film 17 and the aluminum film 18 are formed in this order on the whole surface of the substrate by a sputtering method, etc., and then, as shown in FIG. 21, by photolithography and etching, the stacked film of the titanium film 17 and the aluminum film 18 forms the source electrode 9b, the source line 9, the source signal input terminal 9c, the first multilayer structure 50 serving as the drain electrode 10 later, and the second multilayer structure 54 constituting the terminal portion 53 later. As well as the terminal portion island-shaped semiconductor layer 40, the second multilayer structure 54 is not formed in a region in which the contact hole 41 is to be formed in a subsequent step, and the gate insulating film 7 is exposed.

Next, the resist coated on the whole of the substrate is half etched, thereby forming a resist pattern 61 on each of the first multilayer structure 50 and the second multilayer structure 54, the resist pattern 61 located on the first multilayer structure 50 having a thickness different from that located on the second multilayer structure 54, as shown in FIG. 21. The resist pattern 61 located on the gate electrode 2b has the center portion having a relatively thicker thickness. The resist pattern 61 located on the auxiliary capacitor electrode 4b has a relatively thinner thickness as a whole. The resist pattern 61 located on the lower terminal layer 4a is formed to have a thick thickness which is approximately equal to that of the resist pattern 61 located on the gate electrode 2b.

Subsequently, as shown in FIGS. 22 and 23, an ashing process with respect to the resist patterns 61, and an etching process with respect to the first multilayer structure 50 and the second multilayer structure 54 are repeatedly performed, thereby etching and removing part of the aluminum film 18 of the first multilayer structure 50 (part of the aluminum film 18 exposed from the resist pattern 61) on the auxiliary capacitor electrode 4b. Then, the resist pattern 61 is removed by separation.

Then, as well as the first embodiment, the opening formation step, the electrode portion formation step, the contact hole formation step, and the pixel electrode formation step in FIG. 6 and subsequent figures are sequentially performed.

In this way, as shown in FIG. 24, in the third embodiment, as well as the second embodiment, the photolithography is performed 5 times, the film formation step is performed 5 times, the etching step is performed 6 times, and the separation step is performed 4 times.

Therefore, according to the third embodiment, the number of the masks can be reduced while an advantage similar to the advantage of the first embodiment is achieved.

### [Other Embodiments]

In the above embodiments, the liquid crystal display devices are described as examples, the present invention is not limited to such devices, and can widely applied to other display devices such as organic EL display devices having TFTs, and other switching elements.

The present invention is not limited to the first-third embodiments, and the present invention includes structures in which the first-third embodiments are combined as appropriate.

### INDUSTRIAL APPLICABILITY

As described above, the present invention is useful for display devices, for example, liquid crystal display devices, etc. and a method for fabricating such devices.

### DESCRIPTION OF REFERENCE CHARACTERS

- S: Liquid Crystal Display Device
- 1: Insulating Substrate
- 7: Gate Insulating Film
- 8: TFT Portion Island Shaped Semiconductor Layer
- 9b: Source Electrode
- 10: Drain Electrode (Electrode Portion)
- 11: TFT (Switching Element)
- 12: PAS Film (Protective Film)
- 14: Pixel Electrode
- 15: Contact Hole
- 17: Titanium Film (First Conducting Film)
- 18: Aluminum Alloy Film (Second Conducting Film)
- 21: Planarized film
- 28: Contact Region
- 29: Opening
- 31: TFT Substrate (First Substrate)
- 32: Counter Substrate (Second Substrate)
- 33: Liquid Crystal Layer
- 50: First Multilayer Structure
- 51: TFT Portion
- 52: Contact Hole Portion
- 53: Terminal Portion
- 54: Second Multilayer Structure
- 56: Mask Pattern

## Claims

1. A method for fabricating a display device including a first substrate having a plurality of switching elements, and a plurality of electrode portions each of which is electrically connected to a corresponding one of the switching elements, and a second substrate provided to face the first substrate, each of the electrode portions having a first conducting film, and a second conducting film stacked on the first conducting film and is made of a low resistance metal film whose electrical resistance is lower than that of the first conducting film, the method comprising the steps of:
forming a multilayer structure in which the first conducting film and the second conducting film are stacked in this order on a substrate constituting the first substrate;
removing part of the second conducting film and forming a contact region in which the first conducting film does not overlap with the second conducting film, thereby forming each of the electrode portions from the multilayer structure;
forming a planarized film made of a photosensitive material on the substrate on which each of the electrode portions is formed to cover the electrode portions, thereby forming a contact hole located inside the contact region and passing through the planarized film; and
forming a pixel electrode on a surface of the planarized film to cover part of the first conducting film located inside the contact hole and exposed from the planarized film.

2. The method of claim 1, further comprising the step of
forming a protective film covering the multilayer structure, and forming an opening in the protective film so that part of the second conducting film of the multilayer structure is exposed from the protective film,
wherein
in the step of forming the electrode portions, the part of the second conducting film exposed in the opening of the protective film is removed to form the contact region.

3. The method of claim 2, wherein
in the step of forming the opening in the protective film, a mask pattern made of a resist is formed on a surface of the protective film, thereby etching part of the protective film exposed from the mask pattern.

4. The method of claim 1, wherein
after a protective film covering the electrode portions is formed, a step of forming the planarized film on the protective film to form the contact hole is performed.

5. The method of any one of claims 1-4, wherein
the low resistance metal film constituting the second conducting film is an aluminum film or an aluminum alloy film including aluminum as a main component.

6. The method of any one of claims 1-5, wherein
the first conducting film is a titanium film.

7. The method of any one of claims 1-6, wherein
the display device is a liquid crystal display device in which a liquid crystal display layer is provided between the first substrate and the second substrate.

8. A display device, comprising:
a first substrate having a plurality of switching elements, and a plurality of electrode portions having a plurality of electrode portions each of which is electrically connected to a corresponding one of the switching elements; and
a second substrate provided to face the first substrate, each of the electrode portions having a first conducting film, and a second conducting film stacked on the first conducting film and made of a low resistance metal film whose electrical resistance is lower than that of the first conducting film,
wherein
each of the electrode portions has a contact region in which the first conducting film does not overlap with the second conducting film,
a planarized film made of a photosensitive material and covering each of the electrode portions is formed on the first substrate,
a contact hole passing through the planarized film is formed in an inside of the contact region,
a pixel electrode is formed on a surface of the planarized film to cover part of the first conducting film located inside the contact hole and exposed from the planarized film, and
an inner circumferential surface of the contact hole is formed to be smooth without steps.

9. The display device of claim 8, further comprising
a protective film directly covering the electrode portions,
wherein
the protective film has an opening formed in a region in which the contact region is formed, and
the contact hole is formed inside the contact region and the opening of the protective film.

10. The display device of claim 8, further comprising
a protective film directly covering the electrode portions,
wherein
the protective film has an opening inside the contact region, and
the opening constitutes part of the inner circumferential surface of the contact hole.

11. The display device of any one of claims 8-10, wherein
the low resistance metal film constituting the second conducting film is an aluminum film or an aluminum alloy film including aluminum as a main component.

12. The display device of any one of claims 8-11, wherein
the first conducting film is a titanium film.

13. The display device of any one of claims 8-12, wherein
the display device is a liquid crystal display device in which a liquid crystal display layer is provided between the first substrate and the second substrate.
